(19) Europäisches Patentamt
European Patent Office
Office européen des brevets

(11) **EP 3 872 379 A1**

(12) **EUROPEAN PATENT APPLICATION**

(43) Date of publication:
**01.09.2021   Bulletin 2021/35**

(51) Int Cl.:
**F16K 24/00** *(2006.01)*          **F16K 17/196** *(2006.01)*
**F16H 57/027** *(2012.01)*

(21) Application number: **20214016.6**

(22) Date of filing: **15.12.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.02.2020   JP 2020031488**

(71) Applicant: **TOYOTA JIDOSHA KABUSHIKI KAISHA**
**Toyota-shi, Aichi-ken, 471-8571 (JP)**

(72) Inventors:
• **CAO, Jiadong**
  **Aichi-ken, 471-8571 (JP)**
• **YAMAOKA, Daisuke**
  **Aichi-ken, 471-8571 (JP)**

(74) Representative: **D Young & Co LLP**
**120 Holborn**
**London EC1N 2DY (GB)**

(54) **BREATHER DEVICE**

(57)   A breather device (10) includes a case (11) housing a device in an internal space (12) and a valve (20) tightly sealing the internal space (12). The valve (20) includes a housing (21), a communication path (23), a ventilation passage (28), a seal portion (26), a valve element (60), and a spring. The valve element (60) includes first and second valve members (40, 50). The second valve member (50) abuts against the first valve member (40) to block a valve hole (43) thereof. The spring includes first and second springs (61, 62). The first spring (61) pushes the first valve member (40) against the seal portion in the housing (21) of the valve (20). The second spring (62) pushes the second valve member (50) against the first valve member (40). The valve (20) is brought into a closed valve state with the valve element (60) pushed against the seal portion with the second valve member (50) blocking the valve hole (43). The elastic force of the first spring (61) in the closed valve state is larger than the second spring (62).

## FIG. 2

## Description

BACKGROUND OF THE INVENTION

1. Field of the Invention

The present invention relates to a breather device that includes a case that defines a space and a valve that tightly seals the space. In the breather device, air can be taken into the case and can be exhausted from the case.

2. Description of Related Art

Japanese Unexamined Patent Application Publication No. 2009-106024 (JP 2009-106024 A) discloses a breather device that includes a case that houses a motor-generator in its internal space and a valve that allows air to be taken into the internal space of the case and exhausted from the internal space.

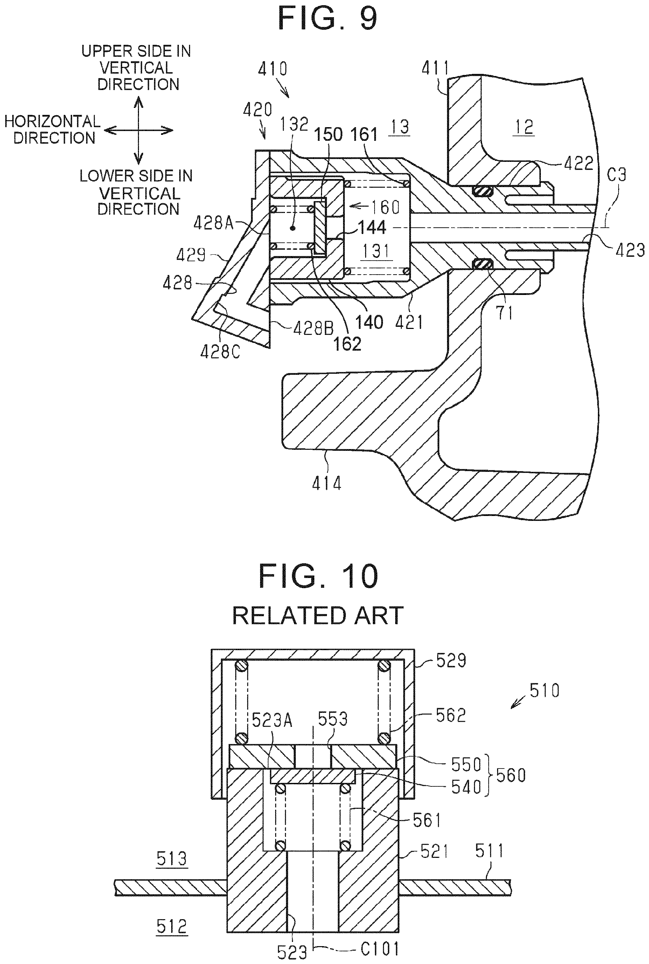

FIG. 10 illustrates, as an example of a breather device according to the related art, a breather device 510 including two valve members that allow air to be taken in and exhausted, as with the breather device disclosed in JP 2009-106024 A. The breather device 510 includes a pipe 521 that penetrates a case 511. The breather device 510 includes a cover 529 that covers the pipe 521 from the outside of the case 511.

The breather device 510 includes a valve element 560 that insulates an internal space 512 and an external space 513 of the case 511 by blocking an opening end 523A, which is positioned outside the case 511, of a passage 523 in the pipe 521. The valve element 560 is composed of two valve members, namely an exhaust valve member 550 in which a hole 553 is formed and an intake valve member 540 that abuts against the exhaust valve member 550 to block the hole 553.

The breather device 510 includes a spring that biases the valve element 560. The spring includes an outside spring 562 that pushes the exhaust valve member 550 against the pipe 521 so as to block the opening end 523A and an inside spring 561 that pushes the intake valve member 540 against the exhaust valve member 550. The outside spring 562 and the inside spring 561 are provided at positions facing each other with the valve element 560 interposed therebetween. The exhaust valve member 550 and the outside spring 562 are disposed between the cover 529 and the pipe 521. The intake valve member 540 and the inside spring 561 are disposed in the passage 523 in the pipe 521.

In the breather device 510, when the pressure in the internal space 512 of the case 511 becomes higher, the intake valve member 540 and the exhaust valve member 550 are displaced toward the cover 529 along an axis C101 that extends along the central axis of the passage 523. Then, the internal space 512 and the external space 513 communicate with each other via the opening end 523A of the pipe 521 to exhaust air from the internal space 512 to the external space 513.

In the breather device 510, when the pressure in the internal space 512 of the case 511 becomes lower, the intake valve member 540 is displaced toward the internal space 512 along the axis C101. Then, the internal space 512 and the external space 513 communicate with each other via the hole 553 of the exhaust valve member 550 to take air from the external space 513 into the internal space 512.

In the breather device 510, when the elastic force of the inside spring 561 at the time when there is no pressure difference between the inside and the outside is stronger than the elastic force of the outside spring 562, the intake valve member 540 and the exhaust valve member 550 are displaced toward the cover 529 to allow communication between the internal space 512 and the external space 513 even when there is no pressure difference between the inside and the outside. In the breather device 510, the case 511 is preferably tightly sealed when the pressure difference between the inside and the outside of the case 511 is small. Therefore, the elastic force of the inside spring 561 at the time when there is no pressure difference between the inside and the outside is set to be weaker than the elastic force of the outside spring 562.

SUMMARY OF THE INVENTION

There is a demand for the breather device to quickly resolve a pressure difference through exhaust when the pressure in the internal space of the case becomes high. When the breather device is placed in an environment in which the case may get wet with water, meanwhile, the pressure in the internal space may be lowered to be lower than the pressure in the external space when air in the case is cooled as the case gets wet with water. If the valve is opened because of the pressure difference at this time, water may enter the case. Therefore, it is not preferable for the breather device that air is taken in immediately when the pressure in the internal space becomes lower than the pressure in the external space since the case gets wet with water.

In the breather device 510 illustrated in FIG. 10, air tends to be taken in in a situation in which the pressure in the internal space is lowered to a smaller degree as the elastic force of the inside spring 561 at the time when there is no pressure difference between the inside and the outside is weaker. Therefore, water tends to enter the case when the pressure in the internal space is lowered since the case gets wet with water. The pressure difference at which air is taken in can be made larger by making the elastic force of the inside spring 561 stronger. In the breather device 510, however, the elastic force of the inside spring 561 cannot be set to be stronger than the elastic force of the outside spring 562. When the elastic force of the outside spring 562 is made stronger in order to make the elastic force of the inside spring 561 larger, the pressure difference at which air is exhausted becomes stronger, which makes it more difficult to resolve a situation in which the pressure in the internal space of the case is high.

When the pressure difference at which air is exhausted and the pressure difference at which air is taken in in the breather device are defined as a valve-opening pressure difference, the valve-opening pressure difference is determined by not only the spring load that affects the elastic force of the spring, but also the relationship between the spring load of the spring and the pressure receiving area that is the area of a surface of the valve element that receives the pressure. That is, the valve-opening pressure difference can be adjusted by changing the pressure receiving area. When the valve element is increased in size, for example, in order to increase the pressure receiving area, however, the size of the housing that houses the valve element is increased. When the valve element is reduced in size, for example, in order to reduce the pressure receiving area, meanwhile, the effect of fluctuations in the size of the valve element due to a manufacturing error on the valve-opening pressure difference tends to be large, and it is difficult to set the valve-opening pressure difference to a prescribed value.

In this manner, it has not been easy to set the pressure difference at which air is exhausted and the pressure difference at which air is taken in in accordance with the demand made for the breather device. Thus, the present invention provides a breather device that operates in accordance with the demand made for the breather device.

An aspect of the present invention relates to a breather device including a case and a valve. The case is configured to house a device in an internal space of the case. The valve is configured to tightly seal the internal space. The breather device is configured to open the valve based on a pressure difference between an external space and the internal space to take air from the external space into the internal space or exhaust air from the internal space to the external space, the external space being a space outside the case. The valve includes a housing, a communication path, a ventilation passage, a seal portion, a valve element, and a spring. The communication path is configured to allow communication between an inside of the housing and the internal space. The ventilation passage is configured to allow communication between the inside of the housing and the external space. The seal portion is provided in the housing and positioned between the communication path and the ventilation passage. The valve element is configured to block communication between the internal space and the external space through the inside of the housing by abutting against the seal portion. The spring is configured to bias the valve element. The valve element is composed of two valve members including a first valve member and a second valve member, the first valve member includes a valve hole that penetrates the first valve member, and the second valve member is configured to block the valve hole by abutting against the first valve member. The spring includes a first spring and a second spring. The first spring is configured to push the first valve member against the seal portion. The second spring is configured to push the second valve member against the first valve member. The first spring and the second spring are provided at positions facing each other with the valve element interposed between the first spring and the second spring. The valve is brought into a closed valve state, in which communication between the communication path and the ventilation passage through the inside of the housing is blocked, by the valve element being pushed against the seal portion with the second valve member blocking the valve hole of the first valve member, the first spring is disposed in a first space, the second spring is disposed in a second space, and an elastic force of the first spring in the closed valve state is larger than an elastic force of the second spring. The first space is a space positioned on the communication path side with respect to the valve element, and the second spring is a space positioned on the ventilation passage side with respect to the valve element, of spaces obtained by the valve element partitioning the inside of the housing when the valve is in the closed valve state.

In the breather device according to the aspect described above, when the pressure in the internal space of the case becomes lower and the force to draw the valve element toward the communication path exceeds the elastic force of the first spring, the valve element is displaced toward the communication path. Therefore, the first space and the second space communicate with each other with a gap formed between the first valve member and the seal portion. Consequently, communication between the internal space and the external space of the case is allowed, which allows air to be taken from the external space into the internal space. When the pressure in the internal space of the case becomes higher and the force to press the second valve member toward the ventilation passage exceeds the elastic force of the second spring, on the other hand, the second valve member is displaced toward the ventilation passage. Since the second valve member is moved away from the first valve member, the first space and the second space communicate with each other with the valve hole of the first valve member opened. Consequently, communication between the internal space and the external space of the case is allowed, which allows air to be exhausted from the internal space to the external space.

The valve is brought into the closed valve state with the valve element pushed against the seal portion with the second valve member blocking the valve hole of the first valve member. The closed valve state can be maintained when there is no pressure difference between the internal space and the external space, since the elastic force of the first spring that presses the first valve member, of the springs that are disposed at positions facing each other with the valve element interposed therebetween, is set to be larger than the elastic force of the second spring that presses the second valve member.

The first valve member is moved away from the seal portion less easily as the elastic force of the first spring in the closed valve state is stronger, for example. Therefore, the pressure difference required to take in air can be set to be larger by making the elastic force of the first spring stronger. On the other hand, the second valve member is moved away from the first valve member more easily as the elastic force of the second spring in the closed valve state is weaker. Therefore, the pressure difference required to exhaust air can be set to be smaller by making the elastic force of the second spring weaker.

That is, the closed valve state can be maintained when there is no pressure difference between the internal space and the external space since the elastic force of the first spring in the closed valve state is set to be larger than the elastic force of the second spring, and the valve-opening pressure difference that meets the demand can be set within such a range that the elastic force of the first spring is larger than the elastic force of the second spring.

With the breather device according to the aspect described above, as described above, the valve-opening pressure difference that meets the demand made for the breather device can be achieved by adjusting the elastic force of the spring without changing the pressure receiving area of the valve element. That is, it is possible to achieve the valve-opening pressure difference that meets the demand made for the breather device without increasing the size of the casing of the valve or without the valve-opening pressure difference being affected by a manufacturing error of the valve element.

In the breather device according to the aspect described above, the first valve member may be in a bottomed cylindrical shape in which the first valve member is open at one end and is blocked by a bottom plate at the other end. The valve hole of the first valve member may penetrate the bottom plate. The second valve member may be in a plate shape. The second valve member and the second spring may be disposed inside the first valve member. When an opening of the ventilation passage on the second space side is defined as a ventilation port, the seal portion may be a wall surface of the housing in which the ventilation port opens. The first valve member may be configured such that an end surface of the first valve member on an opening side abuts against the wall surface so as to surround the ventilation port when in the closed valve state.

With the breather device configured as described above, the second valve member and the second spring are disposed inside the first valve member in a tubular shape. Therefore, the second valve member is displaced inside the first valve member. That is, the first valve member functions as a guide that guides the second valve member that is displaced in accordance with the pressure difference between the internal space and the external space and the elastic force of the spring. Consequently, motion of the second valve member can be stabilized.

In the breather device according to the aspect described above, the first valve member may be in a bottomed cylindrical shape in which the first valve member is open at one end and is blocked by a bottom plate at the other end. The valve hole of the first valve member may penetrate the bottom plate. The second valve member may include a surface on the bottom plate side that projects in a spherical crown shape toward the bottom plate. The second valve member and the second spring may be disposed inside the first valve member. When an opening of the ventilation passage on the second space side is defined as a ventilation port, the seal portion may be a wall surface of the housing in which the ventilation port opens, and the first valve member may be configured such that an end surface of the first valve member on an opening side abuts against the wall surface so as to surround the ventilation port when in the closed valve state.

With the breather device configured as described above, the second valve member and the second spring are disposed inside the first valve member in a tubular shape. Therefore, the second valve member is displaced inside the first valve member. That is, the first valve member functions as a guide that guides the second valve member that is displaced in accordance with the elastic force of the spring and the pressure difference between the internal space and the external space. Consequently, motion of the second valve member can be stabilized.

Further, the second valve member has a surface that projects in a spherical crown shape. Therefore, a part of the second valve member can enter the valve hole when the second valve member abuts against the first valve member so as to block the valve hole. Therefore, the second valve member is easily accommodated at a prescribed position when the second valve member is pressed toward the first valve member. Consequently, the occurrence of a situation in which the valve hole is not blocked even when the second valve member abuts against the first valve member can be suppressed.

In the breather device according to the aspect described above, the first valve member may be in a bottomed cylindrical shape in which the first valve member is open at one end and is blocked by a bottom plate at the other end. The valve hole of the first valve member may penetrate the bottom plate. The second valve member may include a plate portion in a plate shape, a first projecting portion in a columnar shape that projects from a surface of the plate portion on the communication path side, and a second projecting portion in a columnar shape that projects from a surface of the plate portion on the ventilation passage side. The second valve member and the second spring may be disposed inside the first valve member. If an opening of the ventilation passage on the second space side is defined as a ventilation port, the seal portion may be a wall surface of the housing in which the ventilation port opens. When the valve is in the closed valve state, an end surface of the first valve member on an opening side may abut against the wall surface so as to surround the ventilation port, the first projecting portion may be inserted into the valve hole, and the second projecting portion may be inserted into the ventilation passage.

With the breather device configured as described above, displacement of the second valve member can be guided more easily, since the first projecting portion is inserted into the valve hole and the second projecting portion is inserted into the ventilation passage when the valve is in the closed valve state. Consequently, motion of the second valve member can be stabilized better.

In the breather device according to the aspect described above, the first valve member and the second valve member may be in a plate shape, and the seal portion may be a retention wall that partitions the inside of the housing into a portion on the internal space side and a portion on the external space side and that is provided with a through hole that allows communication between the portion on the internal space side and the portion on the external space side. The first valve member may be configured such that a surface of the first valve member on the retention wall side abuts against the retention wall such that the valve element blocks the through hole when in the closed valve state.

In the breather device according to the aspect described above, when an opening of the ventilation passage on the second space side is defined as a ventilation port and an opening of the ventilation passage on the external space side is defined as an open port, the ventilation passage may be shaped such that there are no line segments that are drawn between a point on an imaginary plane surrounded by a periphery of the ventilation port and a point on an imaginary plane surrounded by a periphery of the open port and that pass only in the ventilation passage.

With the breather device configured as described above, the ventilation passage is shaped so as not to allow one to see through from the open port to the ventilation port. Therefore, even if water droplets are carried by a flow of air to enter the ventilation passage from the open port in the case where air is taken in when the pressure in the internal space of the case becomes low, the water droplets that have entered the ventilation passage inevitably collide against the inner wall of the ventilation passage, which makes it difficult for the water droplets to reach the ventilation port. Consequently, entry of water into the internal space of the case during air intake can be suppressed.

In the breather device configured as described above, the ventilation passage may include a bent portion at which the ventilation passage is bent. The bent portion may be located between the ventilation port which is an opening on the second space side, and the open port which is an opening on the external space side.

With the breather device configured as described above, when line segments that may be drawn between a point on an imaginary plane surrounded by the periphery of the ventilation port of the ventilation passage and a point on an imaginary plane surrounded by the periphery of the open port are considered, there are no line segments that pass only in the ventilation passage because of the presence of the bent portion. Thus, even if water droplets enter the ventilation passage, the water droplets collide against the inner wall of the ventilation passage, which makes it difficult for the water droplets to reach the ventilation port. Thus, entry of water into the internal space of the case during air intake can be suppressed.

In the breather device configured as described above, the ventilation port may be positioned above the open port in a vertical direction.

With the breather device configured as described above, the ventilation port is positioned above the open port in the vertical direction. Thus, water droplets tend to fall before reaching the ventilation port even if water droplets enter the ventilation passage from the open port. That is, water droplets do not easily reach the ventilation port, which suppresses entry of water into the internal space of the case during air intake.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

FIG. 1 is a schematic diagram illustrating a breather device according to a first embodiment of the present invention;
FIG. 2 is a sectional view illustrating a valve of the breather device according to the first embodiment;
FIG. 3 is a sectional view illustrating the valve of the breather device according to the first embodiment, illustrating a state in which air is taken in;
FIG. 4 is a sectional view illustrating the valve of the breather device according to the first embodiment, illustrating a state in which air is exhausted;
FIG. 5 illustrates the relationship between the state of the breather device and the pressure difference;
FIG. 6 is a sectional view illustrating a breather device according to a first modification;
FIG. 7 is a sectional view illustrating a breather device according to a second modification;
FIG. 8 is a sectional view illustrating a breather device according to a third modification;
FIG. 9 is a sectional view illustrating a breather device according to a second embodiment of the present invention; and
FIG. 10 is a sectional view illustrating a valve of a breather device according to the related art.

DETAILED DESCRIPTION OF EMBODIMENTS

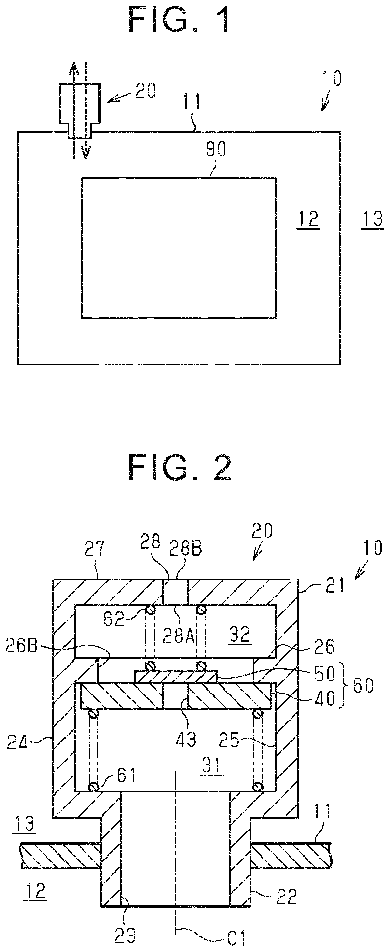

A breather device according to a first embodiment of the present invention will be described below with reference to FIGS. 1 to 5. FIG. 1 illustrates a breather device 10 mounted on a vehicle. The breather device 10 includes a case 11 that houses a transmission 90 of the vehicle. The case 11 defines an internal space 12 that is a space housing the transmission 90. In FIG. 1, the space outside the case 11 is indicated as an external space 13.

The breather device 10 includes a valve 20 attached to the case 11. When the valve 20 is in the closed valve state, the internal space 12 is tightly sealed. The valve 20 opens based on the pressure difference between the internal space 12 and the external space 13. The manner in which the valve 20 is opened will be discussed later. When the valve 20 is open, the breather device 10 can take air from the external space 13 into the internal space 12 as indicated by the dashed arrow in FIG. 1. When the valve 20 is open, in addition, the breather device 10 can exhaust air from the internal space 12 to the external space 13 as indicated by the continuous arrow in FIG. 1.

The structure of the valve 20 will be described with reference to FIGS. 2 to 4.

As illustrated in FIG. 2, the valve 20 includes a housing 21 and a valve element 60 disposed in the housing 21.

The housing 21 is in a cylindrical shape. The housing 21 has an insertion portion 22 inserted into the case 11 and a body portion 24 that defines a space that houses the valve element 60. The body portion 24 is positioned in the external space 13. The diameter of the body portion 24 is larger than the diameter of the insertion portion 22.

The valve 20 includes a communication path 23 that allows communication between the inside of the housing 21 and the internal space 12. The communication path 23 is provided in the insertion portion 22. FIG. 2 indicates an axis C1 that extends along the central axis of the communication path 23.

The valve 20 includes a ventilation passage 28 that allows communication between the inside of the housing 21 and the external space 13. The ventilation passage 28 is formed in a top plate 27 of the body portion 24. The top plate 27 is positioned at an end of the body portion 24 on the opposite side from the insertion portion 22 in the direction in which the axis C1 extends. An opening of the ventilation passage 28 on the side close to the space in the housing 21 is referred to as a ventilation port 28A. The top plate 27 is a wall in which the ventilation port 28A opens. An opening of the ventilation passage 28 on the external space 13 side is referred to as an open port 28B. The central axis of the ventilation passage 28 coincides with the central axis of the communication path 23.

The valve 20 includes a retention wall 26 that is a wall that partitions the space inside of the housing 21 into a portion on the internal space 12 side and a portion on the external space 13 side. The retention wall 26 is positioned in the body portion 24. The retention wall 26 is provided with one through hole 26B as a hole that allows communication between the portion on the internal space 12 side and the portion on the external space 13 side. The through hole 26B is provided at the center of the retention wall 26. The center of the through hole 26B is positioned on the extension line of the axis C1. The retention wall 26 in which the through hole 26B is formed is shaped to project into the housing 21 from the inner surface of a side wall 25 of the body portion 24, which is in a cylindrical shape, to narrow the space in the housing 21 in the sectional structure illustrated in FIG. 2.

The valve element 60 is composed of a first valve member 40 in a circular plate shape and a second valve member 50 in a circular plate shape. The diameter of the first valve member 40 is larger than the inside diameter of the through hole 26B, and smaller than the inside diameter of the body portion 24. There is a gap between the first valve member 40 and the side wall 25. A valve hole 43 is provided in the first valve member 40 as a hole that penetrates the first valve member 40. The diameter of the second valve member 50 is larger than the inside diameter of the valve hole 43, and smaller than the diameter of the first valve member 40. In addition, the diameter of the second valve member 50 is smaller than the inside diameter of the through hole 26B.

The second valve member 50 is disposed on the ventilation passage 28 side with respect to the first valve member 40. The valve hole 43 can be blocked by a surface of the second valve member 50 on the first valve member 40 side as the surface abuts against the first valve member 40.

The first valve member 40 is disposed on the communication path 23 side with respect to the retention wall 26. The first valve member 40 is disposed such that the center of the valve hole 43 is positioned on the extension line of the axis C1. The through hole 26B can be blocked by a surface of the first valve member 40 on the retention wall 26 side as the surface abuts against the retention wall 26 with the second valve member 50 blocking the valve hole 43.

The inside diameter of the through hole 26B is larger than the inside diameter of the communication path 23. The inside diameter of the ventilation passage 28 is smaller than the inside diameter of the communication path 23. The inside diameter of the valve hole 43 is equal to the inside diameter of the ventilation passage 28. The valve 20 includes a spring that biases the valve element 60. The valve 20 includes, as the spring, a first spring 61 and a second spring 62 provided at positions facing each other with the valve element 60 interposed therebetween. The first spring 61 pushes the first valve member 40 against the retention wall 26. The second spring 62 pushes the second valve member 50 against the first valve member 40.

In the valve 20, the through hole 26B is blocked by the valve element 60 when the valve element 60 is pushed against the retention wall 26 with the second valve member 50 blocking the valve hole 43 of the first valve member 40. That is, the valve element 60 that is composed of the first valve member 40 and the second valve member 50 blocks communication between the internal space 12 and the external space 13 through the inside of the housing 21 by blocking the through hole 26B as the valve element 60 abuts against the retention wall 26. The retention wall 26 is a seal portion provided in the housing 21 and positioned between the communication path 23 and the ventilation passage 28. The valve 20 is brought into the closed valve state, in which communication between the communication path 23 and the ventilation passage 28 through the inside of the housing 21 is blocked, when the valve hole 43 and the through hole 26B are blocked. FIG. 2 illustrates the valve 20 in the closed valve state. As discussed in detail later, the valve element 60 is biased by the first spring 61 and the second spring 62 such that the valve 20 is brought into the closed valve state when there is no pressure difference between the internal space 12 and the external space 13. In the valve 20, the spring loads of the first spring 61 and the second spring 62 are set such that the elastic force of the first spring 61 in the closed valve state is larger than the elastic force of the second spring 62. Therefore, the closed valve state is maintained when there is no pressure difference between the internal space 12 and the external space 13.

A space positioned on the communication path 23 side with respect to the valve element 60, of spaces obtained by the valve element 60 partitioning the inside of the housing 21 when the valve 20 is in the closed valve state as illustrated in FIG. 2, is defined as a first space 31. The first spring 61 is disposed in the first space 31. A space positioned on the ventilation passage 28 side with respect to the valve element 60, of the spaces obtained by the valve element 60 partitioning the inside of the housing 21 when the valve 20 is in the closed valve state, is defined as a second space 32. The second spring 62 is disposed in the second space 32.

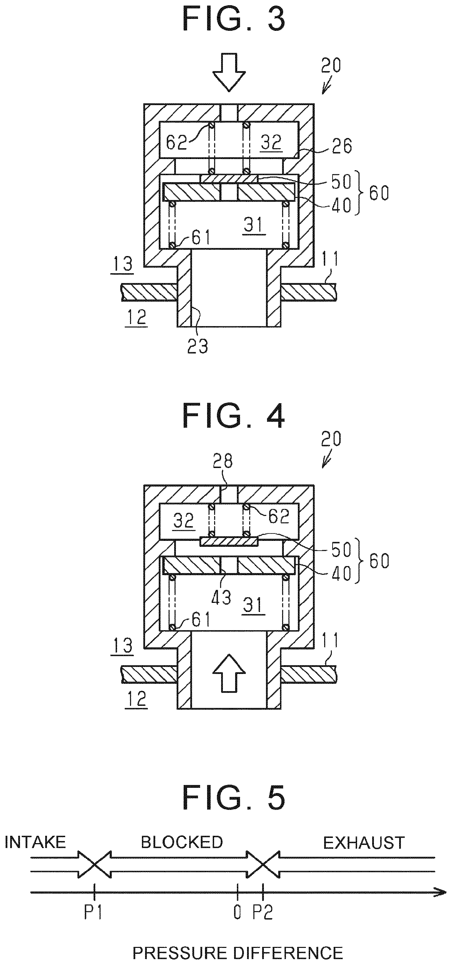

FIG. 3 illustrates the position of the valve element 60 at the time when air is taken from the external space 13 into the internal space 12. When the pressure in the internal space 12 becomes lower and the force to draw the valve element 60 toward the communication path 23 exceeds the elastic force of the first spring 61, the valve element 60 is displaced toward the communication path 23. Since the first valve member 40 is moved away from the retention wall 26, the first space 31 and the second space 32 communicate with each other with a gap formed between the first valve member 40 and the retention wall 26 as illustrated in FIG. 3. When the valve 20 is in this state, communication between the internal space 12 and the external space 13 is allowed. Since the pressure in the internal space 12 is low, air is taken from the external space 13 into the internal space 12.

FIG. 4 illustrates the position of the valve element 60 at the time when air is exhausted from the internal space 12 to the external space 13. When the pressure in the internal space 12 becomes higher and the force to press the second valve member 50 toward the ventilation passage 28 exceeds the elastic force of the second spring 62, the second valve member 50 is displaced toward the ventilation passage 28. Since the second valve member 50 is moved away from the first valve member 40, the first space 31 and the second space 32 communicate with each other with the valve hole 43 of the first valve member 40 opened as illustrated in FIG. 4. When the valve 20 is in this state, communication between the internal space 12 and the external space 13 is allowed. Since the pressure in the internal space 12 is high, air is exhausted from the internal space 12 to the external space 13.

The relationship between the pressure difference between the pressure in the internal space 12 and the pressure in the external space 13 and the state of the valve 20 will be described with reference to FIG. 5. In FIG. 5, the pressure in the external space 13 is used as a reference, and the pressure difference is determined as "0" when the pressure in the internal space 12 is equal to the pressure in the external space 13. The pressure difference has a negative value when the pressure in the internal space 12 is lower than the pressure in the external space 13. Meanwhile, the pressure difference has a positive value when the pressure in the internal space 12 is higher than the pressure in the external space 13.

In the breather device 10, the valve element 60 is displaced toward the communication path 23 when the pressure difference is equal to or less than an intake pressure difference P1 that has a value that is less than "0". That is, a gap is formed between the first valve member 40 and the retention wall 26 as illustrated in FIG. 3. When the pressure difference is equal to or less than the intake pressure difference P1, air can be taken from the external space 13 into the internal space 12 by allowing communication between the first space 31 and the second space 32. The breather device 10 requires the intake pressure difference P1 to take in air.

In the breather device 10, the second valve member 50 is displaced toward the ventilation passage 28 when the pressure difference is equal to or more than an exhaust pressure difference P2 that has a value that is more than "0". That is, the valve hole 43 of the first valve member 40 is opened as illustrated in FIG. 4. When the pressure difference is equal to or more than the exhaust pressure difference P2, air can be exhausted from the internal space 12 to the external space 13 by allowing communication between the first space 31 and the second space 32. The breather device 10 requires the exhaust pressure difference P2 to exhaust air.

In the breather device 10, the housing 21 of the valve 20 is enclosed when the pressure difference is in a range including "0". More particularly, the housing 21 is enclosed when the pressure difference is higher than the intake pressure difference P1 and lower than the exhaust pressure difference P2. That is, the valve 20 is brought into the closed valve state with communication between the internal space 12 and the external space 13 blocked as illustrated in FIG. 2.

In the breather device 10, as illustrated in FIG. 5, the intake pressure difference P1 and the exhaust pressure difference P2 are set such that the magnitude of the intake pressure difference P1 is larger than the magnitude of the exhaust pressure difference P2, that is, the absolute value of "PI" is larger than the absolute value of "P2". The intake pressure difference P1 and the exhaust pressure difference P2 can be set based on the relationship among the area with which the valve element 60 receives a pressure based on the pressure difference, the spring load of the first spring 61, and the spring load of the second spring 62.

In the valve 20, when the area with which the valve element 60 receives a pressure from the second space 32 side is defined as a first pressure receiving area S1, the spring load of the first spring 61 is defined as a first spring load F1, and the spring load of the second spring 62 is defined as a second spring load F2, the magnitude of the intake pressure difference P1 can be represented by the following (Expression 1).

$$[\text{Expression 1}] \qquad |P1| = (F1 - F2)/S1$$

That is, a relationship in which the magnitude of the intake pressure difference P1 becomes larger as a value obtained by subtracting the second spring load F2 from the first spring load F1 is increased and the magnitude of the intake pressure difference P1 becomes larger as the first pressure receiving area S1 is reduced is established. The first spring load F1 is larger than the second spring load F2 so that the elastic force of the first spring 61 in the closed valve state is larger than the elastic force of the second spring 62.

In the valve 20, when the area with which the second valve member 50 receives a pressure from the first space 31 side is defined as a second pressure receiving area S2, the magnitude of the exhaust pressure difference P2 can be represented by the following (Expression 2).

$$[\text{Expression 2}] \qquad |P2| = F2/S2$$

That is, a relationship in which the magnitude of the exhaust pressure difference P2 becomes smaller as the second spring load F2 is reduced and the magnitude of the exhaust pressure difference P2 becomes smaller as the second pressure receiving area S2 is increased is established.

In the valve 20, the first pressure receiving area S1, the second pressure receiving area S2, the first spring load F1, and the second spring load F2 are set based on the above (Expression 1) and (Expression 2) such that the intake pressure difference P1 has a value that is less than "0", the exhaust pressure difference P2 has a value that is more than "0", and the absolute value of the intake pressure difference P1 is larger than the absolute value of the exhaust pressure difference P2. The first pressure receiving area S1 and the second pressure receiving area S2 can be changed in accordance with the shape of the housing 21 or the shape of the valve element 60.

The functions of the first embodiment will be described. There is a demand for the breather device to quickly resolve a pressure difference through exhaust when the pressure in the internal space of the case becomes high. In the case where the breather device is placed in an environment in which the case may get wet with water, meanwhile, the pressure in the internal space may be lowered to be lower than the pressure in the external space when air in the case is cooled as the case gets wet with water. If the valve is opened because of the pressure difference at this time, water may enter the case. Therefore, it is not preferable for the breather device that air is taken in immediately when the pressure in the internal space becomes lower than the pressure in the external space since the case gets wet with water.

With the breather device 10, the magnitude of the intake pressure difference P1 can be set to be larger as the first spring load F1 is increased using the relationship based on the above (Expression 1). As the first spring load F1 is increased, the elastic force of the first spring 61 in the closed valve state is larger, and the first valve member 40 is less easily moved away from the retention wall 26 as a seal portion when the pressure in the internal space 12 is lowered to a small degree.

On the other hand, the magnitude of the exhaust pressure difference P2 can be set to be smaller as the second spring load F2 is reduced using the relationship based on the above (Expression 2). As the second spring load F2 is smaller, the elastic force of the second spring 62 in the closed valve state is smaller, and the second valve member 50 is more easily moved away from the first valve member 40 even when the pressure in the internal space 12 is raised to a small degree.

The effects of the first embodiment will be described.

(1-1) In the breather device 10, the first spring load F1 and the second spring load F2 are set such that the elastic force of the first spring 61 in the closed valve state is larger than the elastic force of the second spring 62. The valve 20 can be maintained in the closed valve state when there is no pressure difference between the internal space 12 and the external space 13, since the elastic force of the first spring 61 is larger than the elastic force of the second spring 62 in the closed valve state.

(1-2) With the breather device 10, the magnitude of the intake pressure difference P1 can be increased by increasing the first spring load F1. Further, the magnitude of the exhaust pressure difference P2 can be reduced by reducing the second spring load F2. In addition, a value obtained by subtracting the second spring load F2 from the first spring load F1 is increased by reducing the second spring load F2, and therefore the magnitude of the intake pressure difference P1 can be increased also by reducing the second spring load F2. Consequently, the magnitude of the intake pressure difference P1 can be increased while setting the magnitude of the exhaust pressure difference P2 to be small.

For the breather device 10, for example, the exhaust pressure difference P2 is preferably set to a value that is close to "0", in order to facilitate immediate resolution of a situation in which the pressure in the internal space 12 is high when the pressure in the internal space 12 is raised. By way of example, the exhaust pressure difference P2 is set to 2 to 5 [kPa]. In this manner, the magnitude of the intake pressure difference P1 can be set to be large even when the magnitude of the exhaust pressure difference P2 is small.

(1-3) The intake pressure difference P1 and the exhaust pressure difference P2 can be set using a relationship based on the above (Expression 1) and (Expression 2). Therefore, the valve 20 can be maintained in the closed valve state when there is no pressure difference between the internal space 12 and the external space 13, and the intake pressure difference P1 and the exhaust pressure difference P2 that meet the demand can be set in such a range that the elastic force of the first spring 61 in the closed valve state is larger than the elastic force of the second spring 62.

(1-4) The breather device 10 can achieve the intake pressure difference P1 and the exhaust pressure difference P2 that meet the demand made for the breather device 10, by adjusting the first spring load F1 and the second spring load F2 without changing the first pressure receiving area S1 or the second pressure receiving area S2.

For example, it is not necessary to reduce the first pressure receiving area S1 in order to increase the magnitude of the intake pressure difference P1. When the size of the valve element is reduced in order to reduce the first pressure receiving area S1, the effect of fluctuations in the size of the valve element due to a manufacturing error on the intake pressure difference P1 tends to be large, and it is difficult to set the intake pressure difference P1 to a prescribed value.

In addition, for example, it is not necessary to increase the second pressure receiving area S2 in order to reduce the magnitude of the exhaust pressure difference P2. When the size of the valve element is increased in order to increase the second pressure receiving area S2, the size of the housing that houses the valve element is also increased, which increases the size of the valve.

With the breather device 10, on the contrary, the intake pressure difference P1 and the exhaust pressure difference P2 that meet the demand made for the breather device 10 can be achieved without causing the issues described above due to a change in the first pressure receiving area S1 or the second pressure receiving area S2.

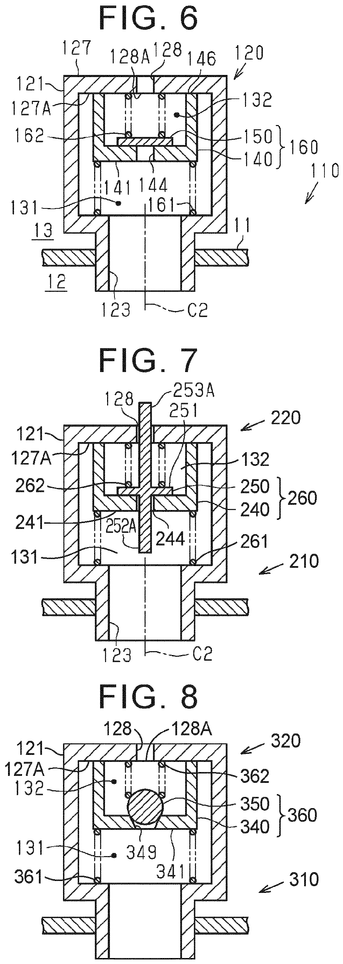

The first embodiment may be modified as follows. The first embodiment and the following modifications can be combined with each other unless such an embodiment and modifications technically contradict with each other. First, a first modification of the first embodiment will be described. A breather device 110 according to the first modification illustrated in FIG. 6 is different from the breather device 10 according to the first embodiment in that a valve element 160 of a valve 120 is composed of a first valve member 140 in a bottomed cylindrical shape and a second valve member 150 in a plate shape. FIG. 6 indicates an axis C2 that extends along the central axis of a communication path 123.

The first valve member 140 that constitutes the valve element 160 is in a cylindrical shape. The first valve member 140 is open at one end, and is blocked by a bottom plate 141 at the other end. A valve hole 144 is formed in the first valve member 140 as a hole that penetrates the bottom plate 141. The first valve member 140 is disposed in a housing 121 such that the central axis of the cylinder coincides with the axis C2. The first valve member 140 is disposed with the bottom plate 141 positioned on the communication path 123 side and with an opening 146 positioned on the ventilation passage 128 side.

The second valve member 150 and a second spring 162 are disposed inside the first valve member 140. The housing 121 is not provided with the retention wall 26, unlike the breather device 10. In the breather device 110, the inner surface of a wall in which a ventilation port 128A opens serves as a seal portion in place of the retention wall 26. That is, an inner surface 127A of a top plate 127 of the housing 121 serves as a seal portion. In the breather device 110, the top plate 127 is a wall in which the ventilation port 128A opens. The inner surface 127A is a wall surface of the top plate 127 that is a wall in which the ventilation port 128A opens. When the valve 120 is in the closed valve state, an end surface of the first valve member 140 on the opening 146 side abuts against the inner surface 127A so as to surround the ventilation port 128A. In the breather device 110, a space positioned on the communication path 123 side with respect to the valve element 160, that is, a space outside the first valve member 140, is defined as a first space 131. Meanwhile, a space positioned on the ventilation passage 128 side with respect to the valve element 160, that is, a space inside the first valve member 140, is defined as a second space 132.

The breather device 110 illustrated in FIG. 6 is different from the breather device 10 according to the first embodiment in the configuration of the valve element 160 and the position of the seal portion, but is the same as the breather device 10 in the arrangement of the valve members and the arrangement of the springs in the housing 121. Therefore, the relationship of the above (Expression 1) and (Expression 2) is established. The intake pressure difference P1 and the exhaust pressure difference P2 can be set in the same manner as in the first embodiment. That is, the same effects as those of the first embodiment in (1-1) to (1-4) can be achieved.

In the breather device 110, further, the second valve member 150 and the second spring 162 are disposed inside the first valve member 140 in a tubular shape. Therefore, the second valve member 150 is displaced inside the first valve member 140. That is, the first valve member 140 functions as a guide that guides the second valve member 150 that is displaced in accordance with the pressure difference between the internal space 12 and the external space 13 and the elastic forces of the first spring 161 and the second spring 162. Consequently, motion of the second valve member 150 can be stabilized.

· Next, a second modification of the first embodiment will be described. A breather device 210 according to the second modification illustrated in FIG. 7 is different from the breather device 110 illustrated in FIG. 6 in the shape of a second valve member 250. The second valve member 250 includes a first projecting portion 252A and a second projecting portion 253A in a circular column shape that project from the center of a plate portion 251 in a circular plate shape along the axis C2. The first projecting portion 252A projects from a surface of the plate portion 251 on the communication path 123 side. The second projecting portion 253A projects from a surface of the plate portion 251 on the ventilation passage 128 side. The diameters of the first projecting portion 252A and the second projecting portion 253A are smaller than the diameter of the plate portion 251. The first projecting portion 252A is inserted into a valve hole 244. Further, the second projecting portion 253A is inserted into the ventilation passage 128.

The breather device 210 can achieve the same effects as those of the breather device 110 illustrated in FIG. 6. In the breather device 210, further, displacement of the second valve member 250 is easily guided along the axis C2. Consequently, motion of the second valve member 250 can be stabilized better.

The effect of guiding the second valve member 250 can be achieved when the first projecting portion 252A is inserted into the valve hole 244 or the second projecting portion 253A is inserted into the ventilation passage 128. In addition, the lengths of projection of the first projecting portion 252A and the second projecting portion 253A from the plate portion 251 are exemplary, and are changeable.

In addition, the shape of the first projecting portion 252A may be any shape that enables insertion into the valve hole 244, and is not limited to a circular column shape. Similarly, the shape of the second projecting portion 253A may be any shape that enables insertion into the ventilation passage 128, and is not limited to a circular column shape.

Furthermore, the first projecting portion 252A may not necessarily project from the center of the plate portion 251 along the axis C2 as long as the first projecting portion 252A projects from a surface of the plate portion 251 on the communication path 123 side. Similarly, the second projecting portion 253A may not necessarily project from the center of the plate portion 251 along the axis C2 as long as the second projecting portion 253A projects from a surface of the plate portion 251 on the ventilation passage 128 side.

Next, a third modification of the first embodiment will be described. A breather device 310 according to the third modification illustrated in FIG. 8 is different from the breather device 110 illustrated in FIG. 6 in that a second valve member 350 is in a spherical shape. Further, the diameter of a valve hole 349 that penetrates a bottom plate 341 of a first valve member 340 is increased from the first space 131 side toward the second space 132.

The breather device 310 can achieve the same effects as those of the breather device 110 illustrated in FIG. 6. In the breather device 310, further, the diameter of the valve hole 349 of the first valve member 340 is increased toward the second space 132. Therefore, the second valve member 350 can be caused to abut against the inner wall of the valve hole 349 when the second valve member 350 in a spherical shape abuts against the first valve member 340 so as to block the valve hole 349. Therefore, the second valve member 350 is easily accommodated at a prescribed position when the second valve member 350 is pressed toward the first valve member 340. Consequently, the occurrence of a situation in which the valve hole 349 is not blocked even when the second valve member 350 abuts against the first valve member 340 can be suppressed.

It is not essential that the diameter of the valve hole 349 should be increased. Also, when the diameter of the valve hole 349 is not increased toward the second space 132, a part of the second valve member can enter the valve hole in the case where the second valve member abuts against the first valve member so as to block the valve hole when the second valve member 350 is in a spherical shape. Consequently, the second valve member is easily accommodated at a prescribed position when the second valve member is pressed toward the first valve member.

When the second valve member is shaped to be swelled in a spherical crown shape on the bottom plate 341 side and have a surface that projects toward the bottom plate 341, meanwhile, the same effect as that obtained with the second valve member 350 in a spherical shape described above can be achieved. That is, the second valve member is not limited to being in a spherical shape as illustrated in FIG. 8, and may be in the shape of a spherical segment such as a hemisphere.

While a first valve member in a cylindrical shape is adopted in the breather devices illustrated in FIGS. 6 to 8, the first valve member is not limited to a cylindrical shape as long as the first valve member is in a bottomed cylindrical shape including a bottom plate in which a valve hole is provided. The first valve member 40 and the second valve member 50 in a circulate plate shape according to the first embodiment are examples of valve members in a plate shape.

The shape of the housing 21 according to the first embodiment is exemplary. For example, the diameter of the insertion portion 22 and the diameter of the body portion 24 may be equal to each other. In addition, for example, the retention wall 26 may be positioned more on the communication path 23 side, or more on the ventilation passage 28 side.

The relationship among the respective inside diameters of the communication path 23, the ventilation passage 28, the through hole 26B, and the valve hole 43 indicated in the first embodiment is exemplary. In the first embodiment, the central axis of the ventilation passage 28 coincides with the central axis of the communication path 23. Further, the center of the through hole 26B is positioned on the extension line of the axis C1 that extends along the central axis of the communication path 23. In addition, the first valve member 40 is disposed such that the center of the valve hole 43 is positioned on the extension line of the axis C1. It is not an essential requirement that all the central axes should coincide with each other. In addition, the center of the hole may be misaligned from the extension line of the axis C1.

The transmission 90 according to the first embodiment is an example of the device housed in the case 11. The device housed in the case 11 is not limited to the transmission 90, and may be a motor-generator, for example.

Next, a breather device according to a second embodiment of the present invention will be described with reference to FIG. 9. As illustrated in FIG. 9, a breather device 410 is configured such that the valve element 160 of a valve 420 is composed of the first valve member 140 and the second valve member 150 as in the breather device 110 illustrated in FIG. 6. The valve element 160 is not described in detail.

As illustrated in FIG. 9, the breather device 410 is mounted on a vehicle with an axis C3, which extends along the central axis of a communication path 423, directed in the horizontal direction. In addition, an O-ring 71 is attached to an insertion portion 422 of a housing 421 to seal the boundary between the insertion portion 422 and a case 411.

The case 411 includes a protruding portion 414 that shields the valve 420 from the lower side in the vertical direction. Further, the breather device 410 is different from the breather device 110 in that a lid portion 429 is attached to the housing 421 in place of the top plate 127 in the breather device 110. A ventilation passage 428 that allows communication between the inside of the housing 421 and the external space 13 is provided in the lid portion 429.

The ventilation passage 428 includes a bent portion 428C that is located between a ventilation port 428A, which is an opening on the second space 132 side, and an open port 428B, which is an opening on the external space 13 side, and at which the passage is bent. Further, the ventilation port 428A of the ventilation passage 428 is positioned above the open port 428B in the vertical direction.

When line segments that may be drawn between a point on an imaginary plane surrounded by the periphery of a ventilation port 428A of the ventilation passage 428 and a point on an imaginary plane surrounded by the periphery of the open port 428B are considered, there are no line segments that pass only in the ventilation passage 428 because of the presence of the bent portion 428C.

The functions and the effects of the second embodiment will be described.

(2-1) The breather device 410 achieves the same effects as those of (1-1) to (1-4) in the first embodiment. In addition, the breather device 410 also achieves the effect of stabilizing operation of the second valve member 150 as with the breather device 110 illustrated in FIG. 6.

(2-2) In the breather device 410, the ventilation port 428A is positioned above the open port 428B in the vertical direction. Consequently, water droplets tend to fall before reaching the ventilation port 428A even if water droplets enter the ventilation passage 428 from the open port 428B. That is, water droplets do not easily reach the ventilation port 428A, which suppresses entry of water into the internal space 12 of the case 411 during air intake.

(2-3) The ventilation passage 428 is shaped so as not to allow one to see through from the open port 428B to the ventilation port 428A with the presence of the bent portion 428C. Therefore, even if water droplets are carried by a flow of air to enter the ventilation passage 428 from the open port 428B in the case where air is taken in when the pressure in the internal space 12 of the case 411 becomes low, the water droplets that have entered the ventilation passage 428 inevitably collide against the inner wall of the ventilation passage 428, which makes it difficult for the water droplets to reach the ventilation port 428A. Consequently, entry of water into the internal space 12 of the case 411 during air intake can be suppressed.

(2-4) Since the case 411 includes the protruding portion 414, adhesion of water droplets to the valve 420 can be suppressed when water droplets are splashed up from the lower side of the valve 420 in the vertical direction. Consequently, water droplets do not easily enter the ventilation passage 428.

The second embodiment may be modified as follows. The second embodiment and the following modifications can be combined with each other unless such an embodiment and modifications technically contradict with each other. In the second embodiment, the breather device 410 is mounted on a vehicle with the axis C3 directed in the horizontal direction. The posture in which the breather device 410 is mounted in not limited thereto. For example, the breather device 410 may be mounted with the axis C3 intersecting the horizontal direction.

In the second embodiment, the ventilation passage 428 includes the bent portion 428C. The present invention is not limited thereto. The ventilation passage 428 may be in any shape as long as there are no line segments that may be drawn between a point on an imaginary plane surrounded by the periphery of the ventilation port 428A and a point on an imaginary plane surrounded by the periphery of the open port 428B and that pass only in the ventilation passage 428. For example, the ventilation passage 428 may be curved such that one cannot see through from the open port 428B to the ventilation port 428A. In addition, the ventilation passage 428 may include a labyrinth structure in which the passage is repeatedly bent several times between the ventilation port 428A and the open port 428B.

The valve in each of the breather devices illustrated in FIGS. 2 and 8 may include the lid portion 429. In addition, the valve in the breather device illustrated in FIG. 7 may also be provided with a lid portion with a bent ventilation passage, as in the second embodiment, by shaping the ventilation passage for a predetermined range from the ventilation port so as to secure a space such that the first projecting portion 252A does not interfere when the second valve member 250 is displaced.

**Claims**

1. A breather device (10; 110; 210; 310; 410) comprising:

a case (11; 411) configured to house a device in an internal space (12) of the case (11; 411); and
a valve (20; 220; 320; 420) configured to tightly seal the internal space (12),

wherein the breather device (10; 110; 210; 310; 410) is configured to open the valve (20; 220; 320; 420) based on a pressure difference between an external space (13) and the internal space (12) to take air from the external space (13) into the internal space (12) or exhaust air from the internal space (12) to the external space (13), the external space (13) being a space outside the case (11; 411),
wherein the valve (20; 220; 320; 420) includes a housing (21; 121; 421), a communication path (23; 123; 423), a ventilation passage (28; 128; 428), a seal portion (26; 127A), a valve element (60; 160; 260; 360), and a spring, the communication path (23; 123; 423) being configured to allow communication between an inside of the housing (21; 121; 421) and the internal space (12), the ventilation passage (28; 128; 428) being configured to allow communication between the inside of the housing (21; 121; 421) and the external space (13), the seal portion (26; 127A) being provided in the housing (21; 121; 421) and positioned between the communication path (23; 123; 423) and the ventilation passage (28; 128; 428), the valve element (60; 160; 260; 360) being configured to block communication between the internal space (12) and the external space (13) through the inside of the housing (21; 121; 421) by abutting against the seal portion (26; 127A), and the spring being configured to bias the valve element (60; 160; 260; 360);
wherein the valve element (60; 160; 260; 360) is composed of two valve members including a first valve member (40; 140; 240; 340) and a second valve member (50; 150; 250; 350), the first valve member (40; 140; 240; 340) includes a valve hole (43; 144; 244; 349) that penetrates the first valve member (40; 140; 240; 340), and the second valve member (50; 150; 250; 350) is configured to block the valve hole (43; 144; 244; 349) by abutting against the first valve member (40; 140; 240; 340);
wherein the spring includes a first spring (61; 161; 261; 361) and a second spring (62; 162; 262; 362), the first spring (61; 161; 261; 361) is configured to push the first valve member (40; 140; 240; 340) against the seal portion (26; 127A), the second spring (62; 162; 262; 362) is configured to push the second valve member (50; 150; 250; 350) against the first valve member (40; 140; 240; 340), and the first spring (61; 161; 261; 361) and the second spring (62; 162; 262; 362) are provided at positions facing each other with the valve element (60; 160; 260; 360) interposed between the first spring (61; 161; 261; 361) and the second spring (62; 162; 262; 362); and
wherein the valve (20; 420) is brought into a closed valve state, in which communication between the communication path (23; 123; 423) and the ventilation passage (28; 128; 428) through the inside of the housing (21; 121; 421) is blocked, by the valve element (60; 160; 260; 360) being pushed against the seal portion (26; 127A) with the second valve member (50; 150; 250; 350) blocking the valve hole (43; 144; 244; 349) of the first valve member (40; 140; 240; 340), the first spring (61; 161; 261; 361) is disposed in a first space (31; 131), the second spring (62; 162; 262; 362) is disposed in a second space (32; 132), an elastic force of the first spring (61; 161; 261; 361) in the closed valve state is larger than an elastic force of the second spring (62; 162; 262; 362), and the first space (31; 131) is a space positioned on the communication path (23; 123; 423) side with respect to the valve element (60; 160; 260; 360), and the second space (32; 132) is a space positioned on the ventilation passage (28; 128; 428) side with respect to the valve element (60; 160; 260; 360), of spaces obtained by the valve element (60; 160; 260; 360) partitioning the inside of the housing (21; 121; 421) when the valve (20; 420) is in the closed valve state.

2. The breather device (110) according to claim 1, wherein:

the first valve member (140) is in a bottomed cylindrical shape in which the first valve member (140) is open at one end and is blocked by a bottom plate at the other end;
the valve hole (144) of the first valve member (140) penetrates the bottom plate;
the second valve member (150) is in a plate shape;
the second valve member (150) and the second spring (162) are disposed inside the first valve member (140);
when an opening of the ventilation passage (128) on the second space (132) side is defined as a ventilation port (128A), the seal portion (127A) is a wall surface of the housing (121) in which the ventilation port (128A) opens; and
the first valve member (140) is configured such that an end surface of the first valve member (140) on an opening side abuts against the wall surface so as to surround the ventilation port (128A) when in the closed valve state.

3. The breather device (310) according to claim 1, wherein:

the first valve member (340) is in a bottomed cylindrical shape in which the first valve member (340) is open at one end and is blocked by a bottom plate (341) at the other end;
the valve hole (349) of the first valve member (340) penetrates the bottom plate (341);
the second valve member (350) includes a surface on the bottom plate (341) side that projects in a spherical crown shape toward the bottom plate (341);
the second valve member (350) and the second spring (362) are disposed inside the first valve member (340);
when an opening of the ventilation passage (128) on the second space (132) side is defined as a ventilation port (128A), the seal portion (127A) is a wall surface of the housing (121) in which the ventilation port (128A) opens; and
the first valve member (340) is configured such that an end surface of the first valve member (140) on an opening side abuts against the wall surface so as to surround the ventilation port (128A) when in the closed valve state.

4. The breather device (210) according to claim 1, wherein:

the first valve member (240) is in a bottomed cylindrical shape in which the first valve member (240) is open at one end and is blocked by a bottom plate (241) at the other end;
the valve hole (244) of the first valve member (240) penetrates the bottom plate;
the second valve member (250) includes a plate portion in a plate shape, a first projecting portion (252A) in a columnar shape that projects from a surface of the plate portion on the communication path (123) side, and a second projecting portion (253A) in a columnar shape that projects from a surface of the plate portion on the ventilation passage (128) side;
the second valve member (250) and the second spring (262) are disposed inside the first valve member (240);
when an opening of the ventilation passage (128) on the second space (132) side is defined as a ventilation port (128A), the seal portion (127A) is a wall surface of the housing (121) in which the ventilation port (128A) opens; and
when in the closed valve state, an end surface of the first valve member (240) on an opening side abuts against the wall surface so as to surround the ventilation port (128A), the first projecting portion (252A) is inserted into the valve hole (244), and the second projecting portion (253A) is inserted into the ventilation passage (128).

5. The breather device (10) according to claim 1, wherein:

the first valve member (40) and the second valve member (50) are in a plate shape;
the seal portion is a retention wall (26) that partitions the inside of the housing (21) into a portion on the internal space (12) side and a portion on the external space (13) side and that is provided with a through hole (26B) that allows communication between the portion on the internal space (12) side and the portion on the external space (13) side; and
the first valve member (40) is configured such that a surface of the first valve member (40) on the retention wall (26) side abuts against the retention wall (26) such that the valve element (60) blocks the through hole (26B) when in the closed valve state.

6. The breather device (410) according to any one of claims 1 to 5, wherein when an opening of the ventilation passage (428) on the second space (132) side is defined as a ventilation port (428A) and an opening of the ventilation passage (428) on the external space (13) side is defined as an open port (428B), the ventilation passage (428) is shaped such that there are no line segments that are drawn between a point on an imaginary plane surrounded by a periphery of the ventilation port (428A) and a point on an imaginary plane surrounded by a periphery of the open port (428B) and that pass only in the ventilation passage (428).

7. The breather device (410) according to claim 6, wherein the ventilation passage (428) includes a bent portion (428C) at which the ventilation passage is bent, the bent portion (428C) being located between the ventilation port (428A) which is an opening on the second space (132) side, and the open port (428B) which is an opening on the external space (13) side.

8. The breather device (410) according to claim 6, wherein the ventilation port (428A) is positioned above the open port (428B) in a vertical direction.

# FIG. 1

# FIG. 2

# FIG. 3

# FIG. 4

# FIG. 5

# FIG. 6

# FIG. 7

# FIG. 8

# FIG. 9

UPPER SIDE IN
VERTICAL
DIRECTION

HORIZONTAL
DIRECTION

LOWER SIDE IN
VERTICAL
DIRECTION

# FIG. 10

## RELATED ART

Europäisches
Patentamt

European
Patent Office

Office européen
des brevets

# EUROPEAN SEARCH REPORT

Application Number

EP 20 21 4016

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FR 2 577 903 A1 (THIBONNET BERNARD [FR]) 29 August 1986 (1986-08-29) * figures 11-13 * | 1-8 | INV. F16K24/00 F16K17/196 F16H57/027 |
| X | US 2015/260106 A1 (CARRERE BERNARD JOSEPH JEAN PIERRE [FR]) 17 September 2015 (2015-09-17) * paragraph [0001]; figures 2-6 * | 1,3,6-8 | |
| X | US 4 561 559 A (RUTAN FRED E [US] ET AL) 31 December 1985 (1985-12-31) * figures * | 1-8 | |
| X | EP 0 119 174 A1 (FIAT AUTO SPA [IT]) 19 September 1984 (1984-09-19) * figures * | 1-8 | |

TECHNICAL FIELDS
SEARCHED      (IPC)

F16K
F16H
B60K

The present search report has been drawn up for all claims

| Place of search | Date of completion of the search | Examiner |
|---|---|---|
| The Hague | 29 May 2021 | Asensio Estrada, G |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

............................................................................

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 20 21 4016

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2021

| Patent document cited in search report | | Publication date | Patent family member(s) | | Publication date |
|---|---|---|---|---|---|
| FR 2577903 | A1 | 29-08-1986 | NONE | | |
| US 2015260106 | A1 | 17-09-2015 | CA | 2886284 A1 | 10-04-2014 |
| | | | CN | 104769258 A | 08-07-2015 |
| | | | EP | 2904240 A1 | 12-08-2015 |
| | | | ES | 2608631 T3 | 12-04-2017 |
| | | | FR | 2996256 A1 | 04-04-2014 |
| | | | JP | 6254168 B2 | 27-12-2017 |
| | | | JP | 2015531446 A | 02-11-2015 |
| | | | KR | 20150063512 A | 09-06-2015 |
| | | | PL | 2904240 T3 | 28-04-2017 |
| | | | RU | 2015116447 A | 27-11-2016 |
| | | | US | 2015260106 A1 | 17-09-2015 |
| | | | WO | 2014053721 A1 | 10-04-2014 |
| US 4561559 | A | 31-12-1985 | CA | 1237629 A | 07-06-1988 |
| | | | US | 4561559 A | 31-12-1985 |
| EP 0119174 | A1 | 19-09-1984 | EP | 0119174 A1 | 19-09-1984 |
| | | | ES | 278174 U | 01-05-1985 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009106024 A